**Europäisches Patentamt**

**European Patent Office**

**Office européen des brevets**

(19)

(11) Publication number: **0 257 100 B1**

# EUROPEAN PATENT SPECIFICATION

(45) Date of publication of patent specification: **29.04.92**　(51) Int. Cl.⁵: **G01D 5/245**

(21) Application number: **87901632.7**

(22) Date of filing: **14.02.87**

(86) International application number:
**PCT/JP87/00097**

(87) International publication number:
**WO 87/05101 (27.08.87 87/19)**

(54) **PULSE DISTRIBUTION TYPE POSITION DETECTOR.**

(30) Priority: **14.02.86 JP 29023/86**

(43) Date of publication of application:
**02.03.88 Bulletin 88/09**

(45) Publication of the grant of the patent:
**29.04.92 Bulletin 92/18**

(84) Designated Contracting States:
**DE FR GB**

(56) References cited:
**JP-A- 5 419 773**
**JP-A-56 118 611**
**JP-A-61 120 920**
**US-A- 4 225 931**
**US-A- 4 547 858**

**MACHINE DESIGN, vol. 55, no. 1, January 1983, pages 87-91, Cleveland, Ohio, US; E.H. FRIEDMAN: "Resolvers and synchros for microcomputers"**

(73) Proprietor: **FANUC LTD.**
**3580, Shibokusa Aza-Komanba, Oshino-mura Minamitsuru-gun, Yamanashi 401-05(JP)**

(72) Inventor: **SAKANO, Tetsuro**
**1205-3-103, Shibokusa Oshino-mura, Minamitsuru-gun**
**Yamanashi 401-05(JP)**

(74) Representative: **Billington, Lawrence Emlyn et al**
**HASELTINE LAKE & CO Hazlitt House 28 Southampton Buildings Chancery Lane London WC2A 1AT(GB)**

**Description**

The present invention relates to a pulse distribution type position detecting apparatus and, more particularly but not exclusively, to a pulse type position detecting apparatus which detects the position of a movable section of an NC industrial machine or an arm of a manipulator in motion with a high resolution.

Conventionally, various position detectors are used to control different types of machines. Resolvers and synchros are discussed in the publication "Machine Design", Vol. 55(1983), Jan., No.1, pp.87-91. Another type of detector is an encoder which generates two sinusoidal signals (indicated by Va and Vb) having a phase difference of 90 degrees therebetween in response to a change in the position of a movable section of a target machine so as to detect the amount and the direction of the positional change of the movable section.

Conventional encoders direct light emitted from, for example, two light-emitting diodes onto a rotational code plate mounted on a predetermined rotational shaft of the target machine, and cause two light-receiving elements to receive light passing through slits which are provided in the rotational code plate and a fixed slit plate facing the former plate, for photoelectric conversion, whereby sinusoidal signals Va and Vb that have a cycle corresponding to the intervals between the slits of the rotational code plate can be attained in accordance with the rotation of the rotational code plate.

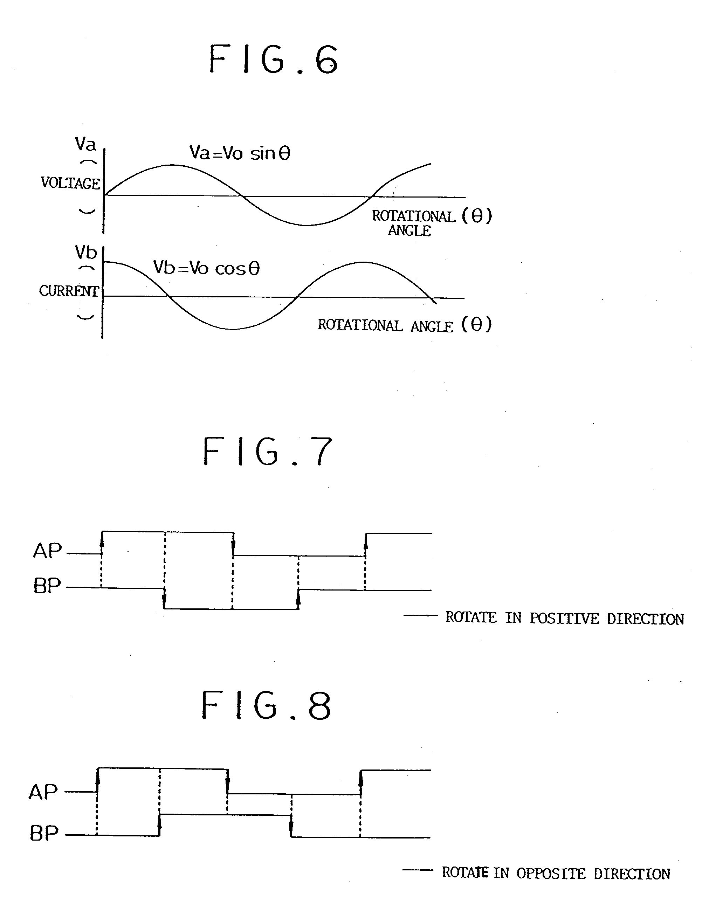

In this case, to provide a 90-degree phase difference between those two sinusoidal signals Va and Vb (see Fig. 6), the fixed plate is provided with two slits separated at an interval equal to 1/4 of the slit interval on the rotational code plate.

The individual sinusoidal signals Va and Vb are input to a comparator included in the encoder, which in turn produces output signals AP and BP that become high and low in accordance with the positive and negative levels of the sinusoidal signals and outputs the signals AP and BP to an external unit as the output signals of the encoder. A controller that controls NC machine tools or the like receives the output signals of the encoder and causes an up/down counter located in the controller to perform a count-up or count-down operation to detect the rotational position of the movable section of the target machine when one of predetermined relationships between the signals AP and BP is satisfied, as mentioned later. Based on the detected position, the controller drives a servo motor using a feedback control technique or the like to thereby control the position of the movable section.

More specifically, a so-called "plus pulse" is generated to sequentially up-count the up/down counter when the rotational code plate, while rotating in a positive direction (e.g., the clockwise direction), reaches a predetermined rotational position, that is:

(1) when the output signal BP is high at the rising of the output signal AP,
(2) when the output signal AP is high at the falling of the output signal BP,
(3) when the output signal BP is low at the falling of the output signal AP, or
(4) when the output signal AP is low at the rising of the output signal BP. (See Fig. 7.)

On the other hand, a so-called "minus pulse" is generated to sequentially down-count the up/down counter when the rotational code plate, while rotating in the other direction (the counterclockwise direction in this case), reaches the predetermined rotational position, that is:

(1) when the output signal BP is low at the rising of the output signal AP,
(2) when the output signal AP is low at the falling of the output signal BP,
(3) when the output signal BP is high at the falling of the output signal AP, or
(4) when the output signal AP is high at the rising of the output signal BP. (See Fig. 8.)

In the above manner, the rotational angle of the rotational code plate or the rotational position of the rotational shaft on which the rotational code plate is mounted can be detected. With a linearly-moving object, the linear movement is converted into the rotational movement of the rotational code plate.

According to the conventional position detecting technique, however, as mentioned above, the pulse (either the plus pulse or minus pulse) to drive the up/down counter is simply generated four times during one cycle (corresponding to the interval between the slits formed in the rotational code plate) of the output signal AP or BP in accordance with the rotation of the rotational code plate, so as to detect the rotational position of the rotational code plate four times within that single cycle. Accordingly, if there are 2000 slits arranged on the periphery of the rotational code plate, the resolution attained for the rotational angle detection is simply 1/(2000x4) = 1/8000 rotations. In short, the conventional position detecting technique cannot provide a detection resolution higher than the one corresponding to the circumference of the rotational code plate divided by four times the number of slits.

As a solution to this problem, the present inventor proposed in the Japanese Patent Disclosure No. 61-110005 a method and an apparatus for effecting the position detection based on the sinusoidal signals Va and Vb with a cycle that corresponds, for example, to 1/1000 of the interval between the slits formed in the rotational code plate. This position detecting method ensures that the moving position of a rotating object or a moving object in general can be detected with a considerably high detection resolution (e.g., 1/(2000x1000 rotations)) as compared with the conventional position detecting method. According to the proposed position detecting method and apparatus, the amount of the movement of the rotating object from the initial position within the intervals between slits is detected in the aforementioned cycle, the detected result is stored in a memory or a register and the stored data is updated for each position detection. To use this method or apparatus with a controller for NC machine tools, it is necessary to provide means for reading out the stored data and subjecting it to data processing in place of the up/down counter. The interface signals between the position detecting apparatus and the controller are significantly complex as compared with the signal AP and BP of the conventional encoder. This makes it difficult to apply the improved position detecting apparatus to an Further attempts to increase resolution in such encoders are disclosed in US-A-4346447 and 4225931, the first of which forms the ratio of the sinusoidal signals to increase resolution, while the second employs circuitry which is present in the precharacterising part of the attached claim 1.

It is an object of the present invention to provide a pulse distribution type position detecting apparatus that can effect a position detection with a higher resoution, while preferred embodiments thereof may use the same type of interface signals for a controller as are used in the conventional encoder.

According to the present invention, there is provided a pulse distribution type position detecting apparatus which comprises:

means for generating sinusoidal signals having a phase difference of 90 degrees therebetween in accordance with movement of a moving object;

means for sample-holding voltage values Va and Vb of the sinusoidal signals in a predetermined cycle shorter than that of the sinusoidal signals; and

A/D converting means for converting the voltage values Va and Vb of the sample-held sinusoidal signals into digital signals Va and Vb, respectively; characterised by:

arithmetic operation means for receiving the digital signals Va and Vb from the A/D converting means, calculating in the predetermined cycle a value $\alpha$ that sets $V = Va \cdot \cos \alpha - Vb \cdot \sin \alpha$ to 0, and calculating a difference $\Delta\alpha$ between a present calculated value and a previously calculated value; and

pulse generating means for generating pulses whose quantity corresponds to the difference $\Delta\alpha$ and represents an amount of movement of the moving object within the predetermined cycle.

As mentioned above, according to the present invention, pulses whose quantity represents the amount of movement of a moving object within a predetermined cycle are produced on the basis of voltage values of two sinusoidal signals, which are generated in accordance with movement of the moving object and have been sampled with a predetermined cycle shorter than that of the sinusoidal signals. Therefore, it is possible to couple the present position detecting apparatus to a controller adapted to use a conventional encoder without modifying the circuitry of the controller and to accurately control the amount of movement of the moving object with a higher resolution.

Brief Description of the Drawings

Fig. 1 is a block diagram of a pulse distribution type position detecting apparatus according to one embodiment of the present invention;
Fig. 2 is a timing chart illustrating the operational timing of each section of the apparatus shown in Fig. 1;
Fig. 3 is a detailed block diagram illustrating a pulse generator shown in Fig. 1;
Fig. 4 is a block diagram of a pulse distribution type position detection apparatus according to another embodiment of the present invention where a computer replaces an arithmetic operation unit shown in Fig. 1;
Fig. 5 is a flowchart illustrating the operation of the apparatus shown in Fig. 4;
Fig. 6 is a waveform diagram for explaining a conventional position detecting method;
Fig. 7 is a view similar to Fig. 6; and
Fig. 8 is a view similar to Fig. 7.

To begin with, the operational principle of a pulse distribution type position detecting circuit of the present invention will be explained below. As disclosed in the Japanese Patent Disclosure No. 61-110005, the voltage values Va and Vb of two sinusoidal signals produced in accordance with the rotational angle of a rotational code plate (generally, the moving position of a moving object) are read out for each constant cycle, for example, 50 micro seconds, and a value $\alpha$ is attained which sets the following equation to 0.

$$V = Va \cdot \cos\alpha - Vb \cdot \sin\alpha \qquad (1)$$

Based on thus obtained α, position data (data representing the rotational angle in this case) is obtained by linearly dividing one cycle of the sinusoidal signals with interpolation into a predetermined number of sections (equi-division). (This one cycle corresponds to the interval between adjacent slits on the rotational code plate). The amount of a change in the position data for a constant cycle is converted into a pulse quantity, which ensures position detection with a high resolution. The reason why the position data should be attained in the above method will now be discussed in detail.

In equation (1) above,

$$Va = V0 \cdot \sin\theta \text{ and } Vb = V0 \cdot \cos\theta$$

where V0 is the amplitude of the two sinusoidal signals and $\theta$ is the rotational position (rotational angle) of the rotational code plate. Substituting these into equation (1) yields

$$V = V0(\sin\theta \cdot \cos\alpha - \cos\theta \cdot \sin\alpha) = V0 \cdot \sin(\theta-\alpha) \qquad (2)$$

Therefore, the value for α that sets $V = 0$ is $\alpha = \theta \pm 2n\pi$ (where n is an integer).

In the case of sinusoidal signal, the value α that sets $V = 0$ is determined as $\alpha = \theta \pm n\pi$. However, setting the conditions $\sin\alpha = \sin\theta$ and $\cos\alpha = \cos\theta$ in order to restrict α, the signs of Va and Vb are the same as those of $\sin\alpha$ and $\cos\alpha$. In this respect, the term α is expressed as $\alpha = \theta \pm 2n\pi$. The value n is for specifying the order of the waveforms so that, once fixed (for example, $n = 0$ when powered on), this value is used to sequentially attain a specific value α that changes with rotation of the rotational code plate thereafter.

When $\theta$ varies with the rotation of the rotational code plate, therefore, if α is attained with a predetermined sampling cycle shorter than the changing speed of $\theta$ (specifically, shorter than the time for the sinusoidal signals to change by $\pi$ with the rotation of the rotational code plate), the amount of a change in $\theta$ or the rotational angle, $\Delta\theta$ (the amount of movement from the initial position), can be properly detected from a change $\Delta\alpha$. That is, assuming that the present rotational position $\theta$ is $\theta1$, the value for α attained that time is $\alpha1 = \theta1 \pm 2n\pi$. And $\alpha2$ that is the value for α obtained in the next sampling cycle is $\alpha2 = \theta2 \pm 2n\pi$. From these two values $\alpha1$ and $\alpha2$, the amount of a change in α, $\Delta\alpha$, is expressed as follows.

$$\begin{aligned}
\Delta\alpha &= \alpha2 - \alpha1 \\
&= (\theta2 \pm 2n\pi) - (\theta1 \pm 2n\pi) \\
&= \theta2 - \theta1 \\
&= \Delta\theta \qquad\qquad \dots (3)
\end{aligned}$$

This means that the amount of a change in α is $\Delta\theta$ that is the amount of a change in the rotational position $\theta$ in one sampling cycle. Accordingly, attaining $\Delta\alpha$ or the amount of change in α yields $\Delta\theta$ (amount of a change in the rotational position $\theta$) so that the amount of movement of the target object from its initial position can be attained. As should be clear from equation (2), a variation in the amplitude V0 does not influence α which satisfies the relationship of $V = 0$. As a result, the rotational position can be detected without influence from a variation in a gap between the rotational code plate and the fixed slit plate which variation originates from the rotation of the code plate, or a variation in amplitude V0 of the sinusoidal signals Va and Vb which occurs with a variation in the amount of light from light-emitting diodes and source voltage. This prevents the occurrence of a detection error that is originated from these error factors, thus ensuring accurate detection of a rotational position with a high resolution.

The aforementioned equation (2) is solved using a proper numerical method such as the Newton-Euler law as discussed in the Japanese Patent Disclosure No. 61-110005. Therefore, the sinusoidal signals Va and Vb are sampled for each constant cycle in which the moving object can move a minute amount, and the numerical method is performed for each sampling by using the α attained on the basis of the previous sampled value as the initial value for the present calculation. In this manner, the value α as well as the positional change $\Delta\theta$ ($= \Delta\alpha = \alpha n - \alpha n\text{-}1$) can be obtained. This positional change $\Delta\theta$ is output as the quantity of pulses.

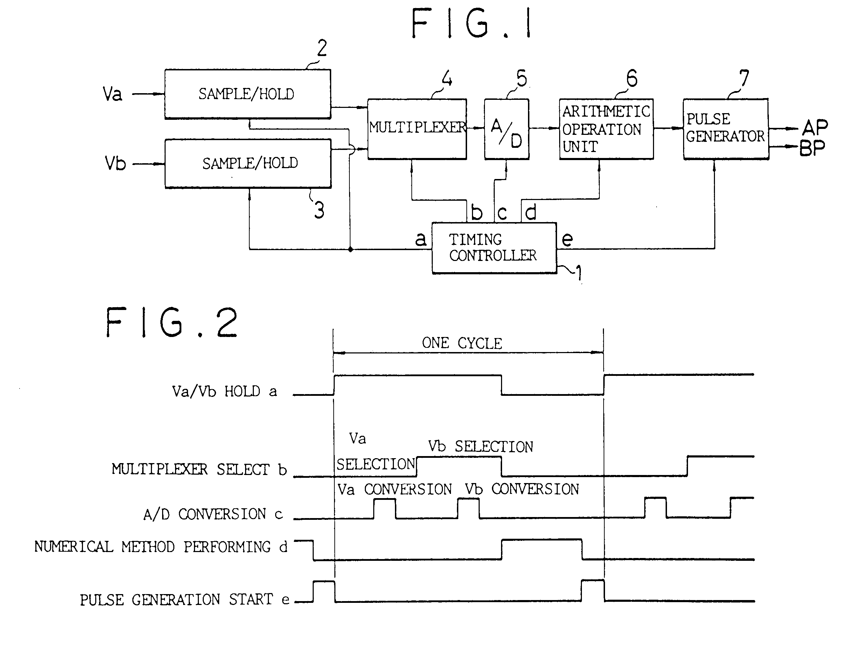

Fig. 1 is a block diagram illustrating a position detecting apparatus according to one embodiment of this invention. This detecting apparatus comprises a timing controller 1, sample/hold circuits 2 and 3, a multiplexer 4, an A/D converter 5 and an arithmetic operation unit 6 and a pulse generator 7. The timing controller 1 produces timing pulses a to e for various commands as shown in Fig. 2. The sample/hold circuits 2 and 3 perform a sample/hold operation on sinusoidal signals Va and Vb, respectively, in accordance with the hold command a that is output from the timing controller 1 for every constant cycle. The multiplexer 4 selectively supplies the sample-held sinusoidal signals Va and Vb to the A/D converter 5 in accordance with the multiplexer select command b from the timing controller 1. In response to the A/D conversion command c from the timing controller 1, the A/D converter 5 converts the selected one of the sinusoidal signals Va and Vb into a digital signal which in turn is supplied to the arithmetic operation unit 6. In accordance with the numerical method performing command d, this arithmetic operation unit 6 attains a value of $\alpha$ that sets the right-hand side of equation (2) to 0 using a numerical method, attains the amount of a change in $\alpha$, $\Delta\alpha$, and, from these values, attains the amount of a change in the rotational position, $\Delta\theta$. The pulse generator 7 is responsive to the pulse generation start command e to output the positional change $\Delta\theta$ as the number of pulses in the next cycle.

The operation of the detecting apparatus according to this embodiment will now be explained.

When the hold command a as shown in Fig. 2 is output from the timing controller 1, the sample/hold circuits 2 and 3 respectively sample-holds the sinusoidal signals Va and Vb. In response to the multiplexer select command b having an L level from the timing controller 1, the multiplexer 4 selects the output of the sample/hold circuit 2 (i.e., the sample-held sinusoidal signal Va) at the beginning stage of the sampling cycle and outputs it to the A/D converter 5. The A/D converter 5 converts the signal Va into a digital signal in accordance with the A/D conversion command c from the timing controller 1 and then outputs the digital signal to the arithmetic operation unit 6. The multiplexer 4 also responds to the multiplexer select command b whose level has been changed to an H level by the timing controller 1, and selects and supplies the output of the sample/hold circuit 3 (the sinusoidal signal Vb) to the A/D converter 5. The A/D converter 5 responds to the A/D conversion command c to convert the signal Vb into a digital signal and outputs it to the arithmetic operation unit 6. The arithmetic operation unit 6 then starts an arithmetic operation in response to the numerical method performing command d from the timing controller 1. Specifically, based on the digital signals Va and Vb, the arithmetic operation unit 6 solves the linear equation (1)

$$V = Va \cdot \cos\alpha - Vb \cdot \sin\alpha = 0$$

using the proper numerical method with the previously-attained $\alpha$ as the initial value so as to attain a new $\alpha$, calculates the difference between the previous $\alpha$ and the new $\alpha$ and outputs the difference as the amount of a positional change.

Suppose that the linear equation is solved using the Newton-Euler law. Then, given

$$V(\alpha) = Va \cdot \cos\alpha - Vb \cdot \sin\alpha,$$

the derivative, $V'(\alpha)$, of $V(\alpha)$ with respect to $\alpha$ is

$$V'(\alpha) = -Va \cdot \sin\alpha - Vb \cdot \cos\alpha,$$

and an approximate solution for the linear equation can be attained by repeating the calculations given below.

To attain position data $\alpha i$ in one detection cycle, first $\alpha i1 = \alpha i0 + \Delta\alpha i0$ is obtained using position data $\alpha i-1$ that has been attained in the previous cycle as the initial approximation of $\alpha i$ ($\alpha i-1 = i0$ to specify the 0-th approximation) and $\alpha i1$ is taken as the first approximation of $\alpha i$. Here,

$$\Delta\alpha i0 = -\{V(\alpha i0)/V'(\alpha i0)\}$$
$$= \frac{Va \cdot \cos\alpha i0 - Vb \cdot \sin\alpha i0}{Va \cdot \sin\alpha i0 + Vb \cdot \cos\alpha i0}$$

Provided that $\alpha in$ is the n-th approximation obtained by repeating the above calculation process, the (n + 1)-th approximation is given by the following equation.

5

EP 0 257 100 B1

$$\alpha i(n+1) = \alpha in + \Delta \alpha in \quad (n = 0, 1, 2, ...)$$

where

$$\Delta \alpha in = -\{V(in)/V'(\alpha in)\}$$

$$= \frac{Va \cdot \cos \alpha in - Vb \cdot \sin \alpha in}{Va \cdot \sin \alpha in + Vb \cdot \cos \alpha in}$$

When the absolute value of $\Delta \alpha in$, $|\Delta \alpha in|$, is $|\Delta \alpha in| < \epsilon$ (where $\epsilon$ is a predetermined minute amount of positional change according to the requested detection accuracy), the repetition of the calculation is stopped and with the approximate solution $\alpha i(n+1)$ taken as position data $\alpha i$ in that detection cycle, the difference between this position data $\alpha i$ and the previously-obtained position data $\alpha i$-1, $(\alpha i - \alpha i$-1$) = \Delta \alpha = \Delta \theta$, is attained as the amount of a change in the rotational position. Thus attained $\Delta \alpha = \Delta \theta$ is supplied with the sign of $\Delta \alpha$ to the pulse generator 7 from the arithmetic operation unit 6. The pulse generator 7 responds to the pulse generation start command e from the timing controller 1 converts pulses whose quantity corresponds to the positional change $\Delta \theta$ with the signs representing the changing direction of the rotational position into signals AP and BP that are similar to the outputs of the conventional encoder, and then outputs as position data. As the resolution of the position data depends on the number of bits in the A/D converter 5, the voltage values of the sinusoidal signals Va and Vb can be read with a high accuracy using an A/D converter with a predetermined number of bits. According to the apparatus of the present embodiment, to provide position data with a high resolution, the number of bits for the A/D converter 5 and the sampling cycle are properly set, one cycle of the sinusoidal signals (which corresponds to the pitch between the adjacent slits on the rotation code plate) is divided by a desired number (e.g., 1000), and the time-depending positional change in that one cycle is subjected to a so-called internal interpolation.

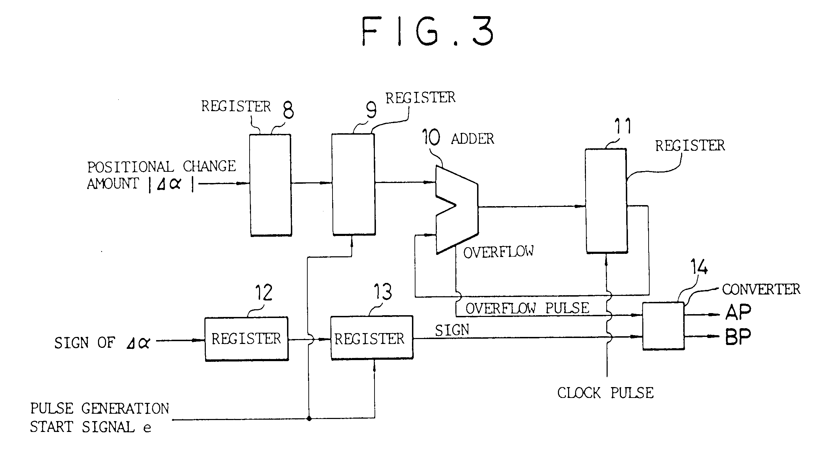

Fig. 3 illustrates a DDA type pulse generator as an example of the aforementioned pulse generator. The absolute value $|\Delta \alpha|$ of the amount of a change in rotational position that is output from the arithmetic operation unit 6 is stored in a register 8 and the sign of $|\Delta \alpha|$ is stored in a register 12. In accordance with the pulse generation start command e from the timing controller 1, the values stored in the registers 8 and 12 are respectively transferred to registers 9 and 13 for temporary storage. And every time a clock pulse is generated from a clock pulse generator (not shown), the value $|\Delta \alpha|$ stored in the register 9 and the content of a register 11 are added in an adder 10 and the addition result is stored in the register 11. Provided that the number of bits of each of the registers 9 and 11 and the adder 10 is n and the number of clock pulses generated during one cycle is $2^n$ (each command pulse from the timing controller 1 being obtained by frequency-dividing the clock pulse with a proper division factor, for instance), the addition is performed $2^n$ times that equal the number of the clock pulses produced in one cycle, and the number of times the overflow from the adder 10 occurs is equal to the number of $|\Delta \alpha|$ set in the register 9 ($2^n \times |\Delta \alpha|/2^n = |\Delta \alpha|$). As a result, overflow pulses that are equal in number to the amount of a change in rotational position $|\Delta \alpha| = |\Delta \theta|$ are output from the adder 10. Since the sign of $\Delta \alpha$ is output from the register 13, the change in rotational position $\Delta \alpha = \Delta \theta$ output has the plus or minus directivity. For instance, given that L (e.g., 1000) is the number of divided sections of the interval (one pitch) of the adjacent slits on the rotational code plate with interpolation, $\theta$ in one slit cycle is $2\pi$ radians so that the interpolation division is carried out with the unit of $2\pi/L$ ($= 2\pi/1000$), thus ensuring the detection of the change in rotational position $\Delta \alpha = \Delta \theta$ with a high resolution. The overflow pulse from the adder 10 and the sign from the register 13 are converted by a converter 14 into signals AP and BP that are similar to the outputs from the encoder.

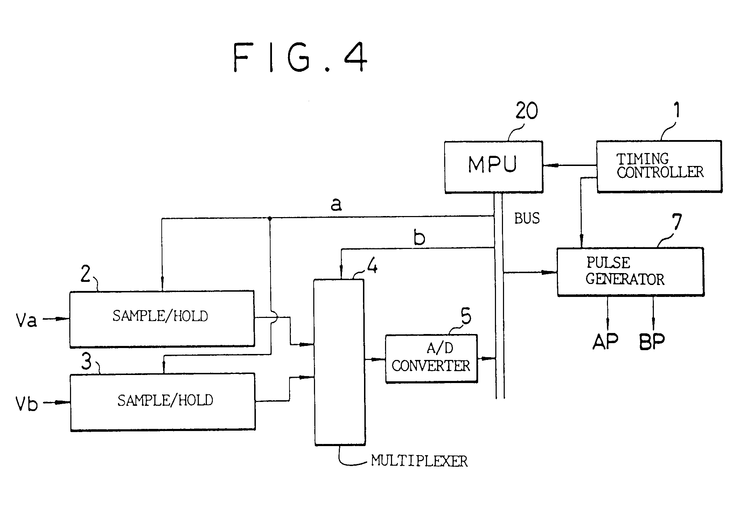

Fig. 4 is a block diagram illustrating another embodiment where the arithmetic operation unit 6 is replaced with a computer. A microprocessor 20 located in the computer generates various commands based on a timing signal coming from the timing controller 1 for every constant cycle. For each constant cycle, the microprocessor 20 sends the hold command a to the individual sample/hold circuits 2 and 3 which are respectively supplied with the sinusoidal signals Va and Vb so as to sample-hold these signals Va and Vb, and sends the multiplexer select command b to the multiplexer 4 which in turn sequentially and selectively transfers the sampled values from the sample/hold circuit 2 and 3 to the A/D converter 5. The digital outputs from the A/D converter 5 are sequentially supplied to the microprocessor 20. Using these digital inputs as Va and Vb in equation (1), the microprocessor 20 calculates the value for $\alpha$ that sets equation (1) or V to be 0 for each cycle. The calculation result or the position data $\alpha$ for each cycle is sequentially stored in a memory of the computer and the difference $\Delta \alpha$ between the present and previous position data $\alpha$ is output to the pulse generator 7.

6

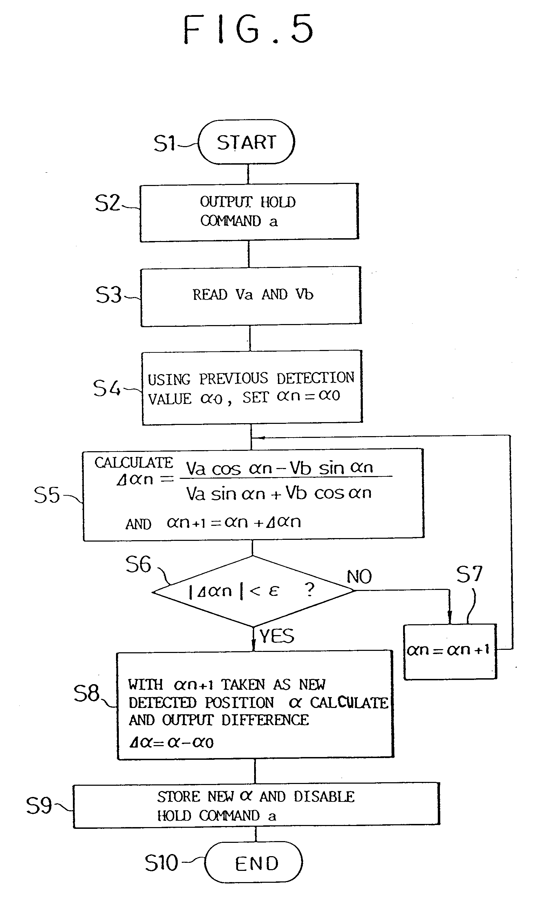

Fig. 5 illustrates a flowchart for the microprocessor 20 to perform the calculation according to the Newton-Euler law. For every constant cycle, the timing controller 1 generates a timing signal in response to which the microprocessor 20 starts the following sequence of processes.

After starting the process sequence in step S1, the microprocessor 20 sends the hold command a to the sample/hold circuits 2 and 3 to sample-hold two sinusoidal signals Va and Vb in step S2. In the subsequent step S3 the microprocessor 20 sends the multiplexer select command b to the multiplexer 4 to output the sample-held sinusoidal signals Va and Vb (analog values) to the A/D converter 5 where the analog values are converted into digital values Va and Vb with a predetermined accuracy, and then latches the digital values.

In step S4, the detecting value (position data) $\alpha 0$ that has been obtained in the previous cycle is read out and is taken as $\alpha n$.

In the next step S5, the following calculations are performed:

$$\Delta \alpha n = \frac{Va \cdot \cos \alpha n - Vb \cdot \sin \alpha n}{Va \cdot \sin \alpha n + Vb \cdot \cos \alpha n}$$

and

$$\alpha n + 1 = \alpha n + \Delta \alpha n$$

where $n = 0, 1, 2, \ldots$ and the calculation should start with $n = 0$.

In step S6 it is determined whether or not $|\Delta \alpha n|$ is smaller than $\epsilon$, which is a value to define the detection accuracy error and is given in advance. If the decision in step S6 is negative, the value $\alpha n + 1$ is set as a new $\alpha n$ (step S7) and the above calculations are performed again. On the other hand, if the decision in step S6 is affirmative, the flow advances to step S8 where the absolute value $|\Delta \alpha|$ of the difference $\Delta \alpha = \alpha - \alpha 0$ between the present detected position data and the previous detected position data $\alpha 0$ is calculated taking $\alpha n + 1$ as new detected position data in that cycle, and the calculated absolute value and the sign of $\Delta \alpha$ are respectively supplied to the registers 8 and 12 of the pulse generator 7. In the subsequent step S9, the new detected position data $\alpha$ is stored in the memory of the computer and the hold command a is disabled and the arithmetic operation in that cycle is completed (step S10).

Then, the microprocessor 20 starts the process for the next cycle. During this period, as described above, the pulse generator 7 outputs the pulses AP and BP which correspond in number to the change in rotational position, $\Delta \alpha = \Delta \theta$, in accordance with the pulse generation start command e from the timing controller 1. Consequently, the position data can be interpolatively detected with high resolution within the interval between the slits on the rotational code plate.

## Claims

1. A pulse distribution type position detecting apparatus, comprising:

   means for generating sinusoidal signals having a phase difference of 90 degrees therebetween in accordance with movement of a moving object;

   means (2,3) for sample-holding voltage values Va and Vb of said sinusoidal signals in a predetermined cycle shorter than that of said sinusoidal signals; and

   A/D converting means (5) for converting said voltage values Va and Vb of said sample-held sinusoidal signals into digital signals Va and Vb, respectively; characterised by:

   arithmetic operation means (6) for receiving said digital signals Va and Vb from said A/D converting means, calculating in said predetermined cycle a value $\alpha$ that sets $V = Va \cdot \cos \alpha - Vb \cdot \sin \alpha$ to 0, and calculating a difference $\Delta \alpha$ between a present calculated value and a previously calculated value; and

   pulse generating means (7) for generating pulses whose quantity corresponds to said difference $\Delta \alpha$ and represents an amount of movement of said moving object within said predetermined cycle.

2. A pulse distribution type position detecting apparatus according to claim 1, wherein said arithmetic operation means (6) is operable to repeatedly calculate a new value $\alpha$ according to the Newton-Euler law with said previously-attained valued $\alpha$ as an initial value until the difference between said previously-attained value and said new value becomes a predetermined minute value.

3. A pulse distribution type position detecting apparatus according to claim 1 or 2, wherein said pulse generating means (7) comprises a first register (9) for storing an absolute value of said value $\alpha$, a second register (11), an adder (10) for adding contents of said first and second registers (9,11) and outputting an addition result to said second register (11), a third register (13) for storing a sign of said value $\alpha$, and a converter (14) for producing pulse signals AP and BP having a 90-degree phase difference therebetween from an output of said third register (13) and an overflow pulse which is produced when an overflow occurs in said adder (10).

**Revendications**

1. Un détecteur de position du type à distribution d'impulsions comprenant :

un moyen pour produire des signaux sinusoïdaux ayant une différence de phase de 90 degrés entre eux conformément au mouvement d'un objet mobile ;

un moyen (2, 3) pour échantillonner et bloquer des valeurs de tension Va et Vb desdits signaux sinusoïdaux dans un cycle prédéterminé qui est plus court que celui desdits signaux sinusoïdaux ; et

un moyen de conversion A/N (5) pour convertir lesdites valeurs de tension Va et Vb desdits signaux sinusoïdaux échantillonnés et bloqués en des signaux numériques Va et Vb, respectivement ; caractérisé par :

un moyen d'opération arithmétique (6) destiné à recevoir lesdits signaux numériques Va et Vb dudit moyen de conversion A/N, calculant pendant ledit cycle prédéterminé une valeur $\alpha$ qui établit que V-Va.cos$\alpha$ Vb.sin$\alpha$ tend vers 0, et calculant une différence $\Delta\alpha$ entre une valeur calculée présente et une valeur calculée précédamment ; et

un moyen de production d'impulsions (7) pour produire des impulsions dont 18 quantité correspond à ladite différence $\Delta\alpha$ et représente une quantité de mouvement dudit objet mobile pendant ledit cycle prédéterminé.

2. Un détecteur de position du type à distribution d'impulsions suivant la revendication 1, dans lequel on fait fonctionner ledit moyen d'opération arithmétique (6) pour calculer à plusieurs reprises une nouvelle valeur $\alpha$ conformément à la loi de Newton-Euler avec ladite valeur $\alpha$ obtenue précédamment en tant que valeur initiale jusqu'à ce que la différence entre ladite valeur obtenue précédamment et ladite nouvelle valeur devienne une valeur minime prédéterminée.

3. Un détecteur de position du type à distribution d'impulsions suivant la revendication 1 ou 2, dans lequel ledit moyen de production d'impulsions (7) comprend un premier registre (9) pour stocker une valeur absolue de ladite valeur $\alpha$, un second registre (11), un additionneur (10) pour additionner les contenus desdits premier et second registres (9, 11) et pour sortir un résultat d'addition vers ledit second registre (11), un troisième registre (13) pour stocker un signe de ladite valeur $\alpha$, et un convertisseur (14) pour produire des signaux d'impulsion AP et BP ayant une différence de phase de 90 degrés entre eux à partir d'une sortie dudit troisième registre (13) et une impulsion de dépassement qui est produite lorsqu'un dépassement a lieu dans ledit additionneur (10).

**Patentansprüche**

1. Mit Impulsverteilung arbeitende Positionsdetektorvorrichtung mit
Mitteln zur Erzeugung von sinusförmigen Signalen mit einer gegenseitigen Phasendifferenz von 90° in Abhängigkeit von der Bewegung eines sich bewegenden Objekts,
Mitteln(2,3) zum Abtasten und Halten von Spannungswerten $V_a$ und $V_b$ der sinusförmigen Signale in einem vorbestimmten Zyklus, der kürzer ist als der der sinusförmigen Signale, und
Analog-Digital-Wandlermitteln (5) zum Umwandeln der Spannungswerte $V_a$ und $V_b$ der abgetasteten und gehaltenen sinusförmigen Signale in digitale Signale $V_a$ bzw. $V_b$,
gekennzeichnet durch
eine die digitalen Signale $V_a$ und $V_b$ aus den Analog-Digital-Wandlermitteln aufnehmende arithmetische Recheneinrichtung (6) zur Berechnung eines Werts $\alpha$, durch den V = $V_a$cos$\alpha$ - $V_b$sin$\alpha$ in dem

vorbestimmten Zyklus zu Null wird, und zur Berechnung der Differenz Δα zwischen einem berechneten laufenden Wert und einem zuvor berechneten Wert, und

eine Impulsgeneratoreinrichtung (7) zur Erzeugung von Impulsen, deren Anzahl der Differenz Δα entspricht und die die Größe der Bewegung des sich bewegenden Objekts in dem vorbestimmten Zyklus repräsentiert.

2. Mit Impulsverteilung arbeitende Positionsdetektoreinrichtung nach Anspruch 1, bei der die arithmetische Recheneinrichtung (6) so betreibbar ist, daß sie mit dem zuvor erreichten Wert α als Anfangswert wiederholt einen neuen Wert α nach dem Newton-Euler-Gesetz berechnet, bis die Differenz zwischen dem zuvor erreichten Wert und dem neuen Wert zu einem vorbestimmten kleinen Wert wird.

3. Mit Impulsverteilung arbeitende Positionsdetektoreinrichtung nach Anspruch 1 oder 2, bei der die Impulsgeneratoreinrichtung (7) ein erstes Register (9) zur Speicherung eines Absolutwerts α aufweist, ferner ein zweites Register (11), einen Addierer (10) zum Addieren der Inhalte des ersten und des zweiten Registers (9, 11) und zur Ausgabe des Additionsergebnisses an das zweite Register (11), ferner ein drittes Register (13) zur Speicherung des Vorzeichens des genannten Werts α und einen Konverter (14) zur Erzeugung von Impulssignalen AP und BP mit einer gegenseitigen Phasendifferenz von 90° aus dem Ausgangssignal des dritten Registes (13) und einem Überlaufimpuls, der erzeugt wird, wenn in dem Addierer (10) ein Überlauf stattfindet.

# FIG.1

Va → SAMPLE/HOLD (2)

Vb → SAMPLE/HOLD (3)

MULTIPLEXER (4) → A/D (5) → ARITHMETIC OPERATION UNIT (6) → PULSE GENERATOR (7) → AP, BP

TIMING CONTROLLER (1)

a  b  c  d  e

# FIG.2

ONE CYCLE

Va/Vb HOLD a

MULTIPLEXER SELECT b — Va SELECTION, Vb SELECTION

A/D CONVERSION c — Va CONVERSION  Vb CONVERSION

NUMERICAL METHOD PERFORMING d

PULSE GENERATION START e

# FIG. 3

REGISTER 8   9 REGISTER   10 ADDER   11 REGISTER

POSITIONAL CHANGE
AMOUNT $|\Delta\alpha|$

OVERFLOW

14 CONVERTER

OVERFLOW PULSE

AP

12   13

SIGN OF $\Delta\alpha$   REGISTER   REGISTER   SIGN   BP

CLOCK PULSE

PULSE GENERATION
START SIGNAL e

EP 0 257 100 B1

# F I G . 4

MULTIPLEXER

# FIG. 5

S1 — ( START )

S2 — OUTPUT HOLD COMMAND a

S3 — READ Va AND Vb

S4 — USING PREVIOUS DETECTION VALUE $\alpha_0$, SET $\alpha_n = \alpha_0$

S5 — CALCULATE $\Delta\alpha_n = \dfrac{Va \cos \alpha_n - Vb \sin \alpha_n}{Va \sin \alpha_n + Vb \cos \alpha_n}$

AND $\alpha_{n+1} = \alpha_n + \Delta\alpha_n$

S6 — $|\Delta\alpha_n| < \varepsilon$ ? — NO

S7 — $\alpha_n = \alpha_{n+1}$

YES

S8 — WITH $\alpha_{n+1}$ TAKEN AS NEW DETECTED POSITION $\alpha$ CALCULATE AND OUTPUT DIFFERENCE $\Delta\alpha = \alpha - \alpha_0$

S9 — STORE NEW $\alpha$ AND DISABLE HOLD COMMAND a

S10 — ( END )

# FIG.6

Va

VOLTAGE

$Va = Vo \sin\theta$

ROTATIONAL ($\theta$) ANGLE

Vb

CURRENT

$Vb = Vo \cos\theta$

ROTATIONAL ANGLE ($\theta$)

# FIG.7

AP

BP

—— ROTATE IN POSITIVE DIRECTION

# FIG.8

AP

BP

—— ROTATE IN OPPOSITE DIRECTION